# EUROPÄISCHE PATENTSCHRIFT

(11) **EP 1 807 654 B1**
(45) Veröffentlichungstag und Bekanntmachung des Hinweises auf die Patenterteilung: **27.02.2008**
(21) Anmeldenummer: 04790044.4
(22) Anmeldetag: 26.10.2004
(51) Int. Cl.: F21S 4/00, H05K 3/28

(54) **BANDFÖRMIGE ANORDNUNG MIT EINER LEITERBAHNSTRUKTUR UND MIT DAMIT ELEKTRISCH VERBUNDENEN ELEKTRONISCHEN BAUTEILEN, INSBESONDERE LICHTBAND MIT LEUCHTELEMENTEN**
STRIP-TYPE ASSEMBLY COMPRISING A PRINTED CONDUCTOR STRUCTURE AND ELECTRONIC COMPONENTS THAT ARE CONNECTED TO SAID STRUCTURE, IN PARTICULAR AN ILLUMINATION STRIP COMPRISING ILLUMINATION ELEMENTS
ENSEMBLE EN FORME DE BANDE COMPRENANT UNE STRUCTURE DE PISTES CONDUCTRICES A LAQUELLE SONT ELECTRIQUEMENT RELIES DES COMPOSANTS ELECTRONIQUES, NOTAMMENT UNE BANDE LUMINEUSE DOTEE D'ELEMENTS LUMINEUX

(43) Veröffentlichungstag der Anmeldung: 18.07.2007
(73) Patentinhaber: Alcan Technology & Management Ltd., 8212 Neuhausen am Rheinfall (CH)
(72) Erfinder: SIMON, Udo, 90409 Nürnberg (DE); LAYER, Hans, 89075 Ulm (DE)
(86) Internationale Anmeldenummer: PCT/DE2004/002381
(87) Internationale Veröffentlichungsnummer: WO 2006/045258

(56) Entgegenhaltungen:
- EP-A- 0 606 006
- EP-A- 0 748 152
- WO-A-98/10219
- US-A- 5 559 681

## Beschreibung

Die vorliegende Erfindung betrifft eine bandförmige Anordnung mit einer Leiterbahnstruktur und mit damit elektrisch verbundenen elektronischen Bauteilen, insbesondere ein Lichtband mit Leuchtelementen, nach dem Oberbegriff des Patentanspruches 1.

Derartige Leiterbahn-/Lichtbänder sind bahn- ode r bandförmig ausgebildet und werden von Rollen abgewickelt, in der erforderlichen Weise konfektioniert und kontaktiert. Das Dokument US-A-5 559 681 beschreibt eine solche bandförmige Anordnung. Nach ihrer Befestigung an bestimmten Orten oder Gegenständen dienen sie dann nach entsprechender Erregung ihrer Leuchtelemente dazu, bestimmte Hinweisfunktionen zu geben. Beispielsweise können sie einen möglichen Fluchtweg oder dergleichen anzeigen.

Die Aufgabe der vorliegenden Erfindung besteht darin, eine solche bandförmige Anordnung, insbesondere ein Lichtband, zu schaffen, das relativ kostengünstig in einer nahezu endlosen Form und zudem wasser- und feuchtigkeitsdicht herstellbar ist.

Diese Aufgabe wird durch eine bandförmige Anordnung mit einer Leiterbahnstruktur und mit damit elektrisch verbundenen elektronischen Bauteilen mit den Merkmalen des Patentanspruches 1 gelöst.

Der wesentliche Vorteil der Erfindung besteht darin, dass die vorliegende bandförmige Anordnung bzw. deren von entsprechenden Vorratsrollen abgewickelten bandförmigen Bestandteile äußerst kostengünstig hergestellt und miteinander zu der erfindungsgemäßen bandförmigen Anordnung verbunden werden können. Dabei können auf einem bandförmigen Leiterbahnträger vorzugsweise im Rotationstiefdruckverfahren von Rolle zu Rolle bei extrem hohen Verarbeitungsgeschwindigkeiten, bei höchster Genauigkeit und mit extrem geringen Ausfallsquoten die Leiterbahnstrukturen aufgebracht werden. Ebenso einfach kann das von einer Vorratsrolle abgewickelte bandförmige Abdeckteil bzw. die -folie in einer Tiefziehstation mit Kavitäten bzw. Bechern versehen werden, die zur Aufnahme der Bauelemente dienen, mit denen der bandförmige Leiterbahnträger bestückt wurde bzw. die dabei mit der Leiterbahnstruktur verbunden wurden. Durch ein einfaches Siegelverfahren, vorzugsweise Heißsiegelverfahren werden dann der von einer Vorratsrolle abgewickelte, mit der Leiterbahnstruktur bedruckte und mit den Bauelementen bestückte bandförmige Leiterbahnträger und das Abdeckteil mit den Kavitäten zur Aufnahme der Bauelemente miteinander völlig wasserdicht verbunden. Auf diese Weise entsteht die bandförmige Anordnung gemäß der vorliegenden Erfindung, bei der es sich vorzugsweise um ein Lichtband mit Leuchtelementen, insbesondere Leuchtdioden, handelt. Diese bandförmige Anordnung kann bedarfsweise von einer Vorratsrolle abgewickelt und in der erforderlichen Weise konfektioniert und mit einer Stromversorgungseinrichtung verbunden werden. Derartige Lichtbänder, die gemäß der vorliegenden Erfindung in verschiedener Weise ausgestaltet und eingesetzt werden können, sind in besonders einfacher und schneller Weise an bestimmten Orten bzw. Gegenständen befestigbar, um durch die Erregung ihrer Leuchtelemente einem Betrachter Informationen zu vermitteln. Beispielsweise können derartige Lichtbänder in öffentlichen Einrichtungen, wie z.B. in Theatern oder Kinos an Wänden oder Böden befestigt werden, um im Notfall Fluchtwege anzuzeigen. Zum Beispiel können derartige Lichtbänder auch in Flugzeugen verwendet werden, um je nach Farbe ihrer Leuchtelemente die Wege zu den einzelnen Sitzbereichen oder im Notfall zu den Notausstiegen anzuzeigen.

Vorteilhafte Weiterbildungen der Erfindung gehen aus den Unteransprüchen hervor.

Im folgenden werden die Erfindung und deren Ausgestaltungen im Zusammenhang mit den Figuren näher erläutert. Es zeigen:
- Figur 1: eine Ansicht von oben auf einen bandförmigen Leiterbahnträger, der mit einer Leiterbahnstruktur und mit Kontaktflächen versehen ist;
- Figur 2: eine Aufsicht von oben auf die mit Leuchtelementen bestückte Anordnung der Figur 1;
- Figur 3: eine Ansicht eines bandförmigen Abdeckteiles mit Kavitäten zur späteren Aufnahme von Bauelementen der Anordnung der Figur 2 und mit Aussparungen für Kontaktflächen;
- Figur 4: eine Aufsicht auf eine Anordnung, bei der der bandförmige Leiterbahnträger mit dem bandförmigen Abdeckteil verbunden ist, wobei die Bauelemente in den Kavitäten angeordnet sind und die Kontaktflächen in den Aussparungen freiliegen;
- Figur 5: einen Querschnitt durch die Anordnung der Figur 4 entlang der Linie VI-VI;
- Figur 6: einen der Figur 5 entsprechenden Querschnitt, wobei jedoch die Kontaktflächen durch eine Abdeckschicht wasserdicht geschützt sind;
- Figur 7: eine Aufsicht auf die Anordnung der Figur 6 in einer zum Gebrauch konditionierten Form, wobei die Anordnung mit einer Stromversorgungseinrichtung verbunden ist;
- Figur 8: eine bevorzugte Ausführungsform der erfindungsgemäßen bandförmigen Anordnung, bei der eingestanzte Ausschnitte und/oder Schnittlinien als Orientierungshilfen zum Kürzen bzw. Abschneiden vorgesehen sind;
- Figuren 9 bis 12: Darstellungen zur Erläuterung des Gebrauchs einer Fixierlehre zum Verbinden der Enden zweier Abschnitte der erfindungsgemäßen bandförmigen Anordnung;
- Figuren 13 und 14: ein Kontaktclipteil zum Verbinden der Enden zweier Abschnitte der erfindungsgemäßen bandförmigen Anordnung durch Aufclipsen;
- Figur 15: eine bevorzugte Ausgestaltung der erfindungsgemäßen bandförmigen Anordnung, bei der der bandförmige Leiterbahnträger und das bandförmige Abdeckteil entlang einer in Längsrichtung verlaufenden Biegelinie miteinander verbunden sind, wobei der Leiterbahnträger mit der Leiterbahnstruktur und den Kontaktflächen versehen ist und das bandförmige Abdeckteil die Kavitäten und Aussparungen aufweist;
- Figur 16: die Anordnung der Figur 15, wobei der bandförmige Leiterbahnträger mit Bauelementen bestückt ist;
- Figur 17: die Anordnung der Figur 16, wobei das bandförmige Abdeckteil um die Biegelinie abgebogen, auf dem bandförmigen Leiterbahnträger zur Auflage gebracht und mit diesem versiegelt ist;
- Figuren 18 bis 21: bevorzugte Ausgestaltungen der Leiterbahnstrukturen und Bauelementeanordnung von erfindungsgemäßen bandförmigen Anordnungen;
- Figur 22: einen Querschnitt durch eine erfindungsgemäße bandförmige Anordnung, wobei der bandförmige Leiterbahnträger eine Aluminiumschicht umfasst, die teilweise mit einer dielektrischen Schicht versehen ist, und wobei die Aluminiumschicht als elektrisch leitende Schicht ausgebildet und zur Stromversorgung der Bauelemente eingesetzt wird; und
- Figur 22a: eine Aufsicht auf die Anordnung der Figur 22.

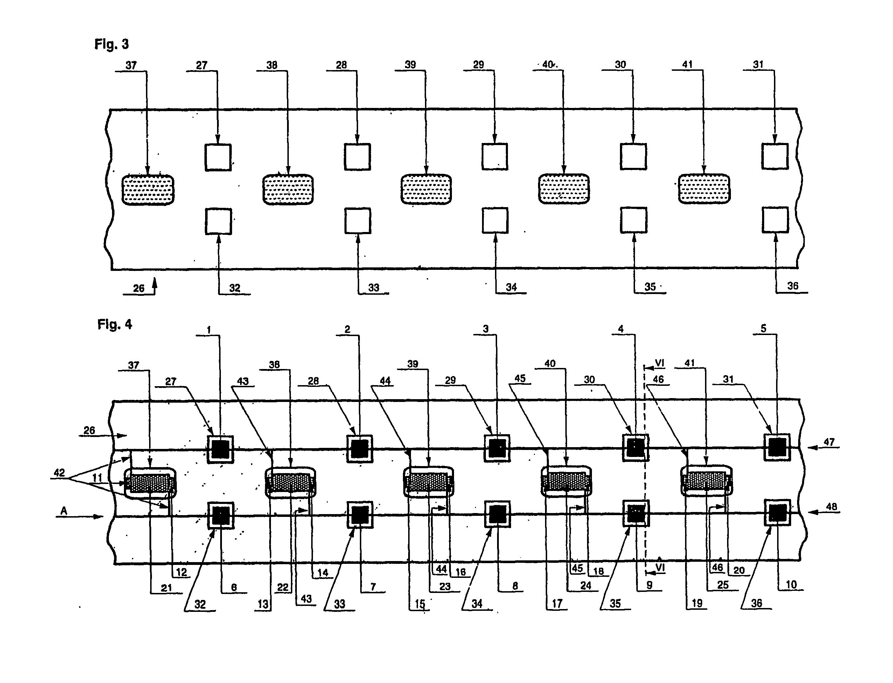

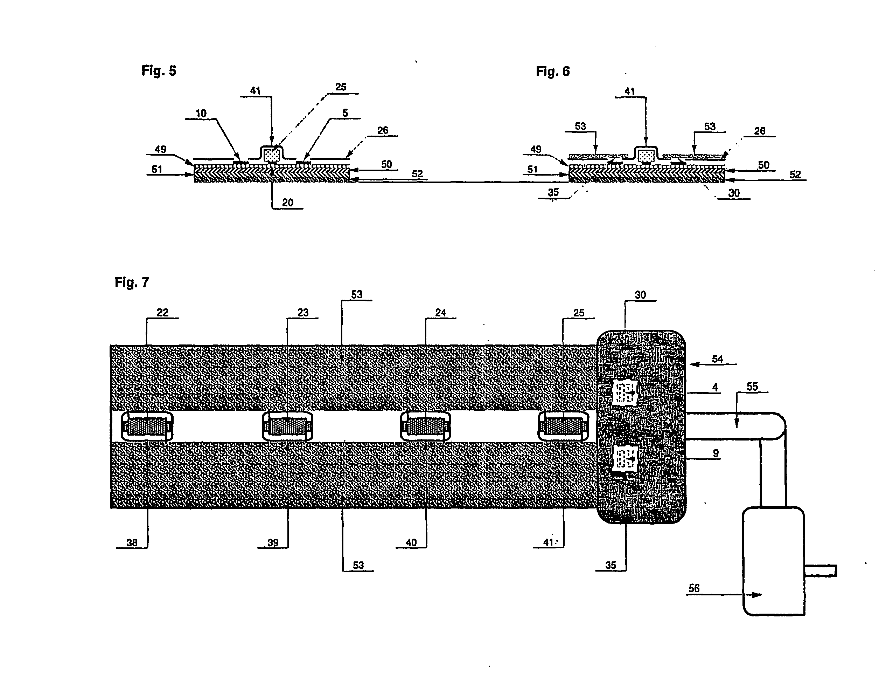

Im folgenden wird zunächst der Aufbau einer ersten Ausführungsform einer erfindungsgemäßen bandförmigen Anordnung, die als Lichtband mit Leuchtelementen ausgestaltet ist, im Zusammenhang mit den Figuren 5 und 6 näher erläutert, wobei die Figur 6 einen Schnitt entlang der Linie VI-VI der Figur 4 darstellt.

Die vorliegende bandförmige Anordnung weist einen bandförmigen Leiterbahnträger A auf, bei dem es sich vorzugsweise um eine elektrisch leitende Schicht, insbesondere um eine Aluminiumschicht 51 handelt, auf der eine dielektrische, isolierende Schicht 50 aufgebracht ist.

Auf der dielektrischen Schicht 50 befindet sich eine Schicht 49 zur Verbindung mit einem Abdeckteil 53, wobei es sich bei dieser Schicht 49 vorzugsweise um eine Heiß-Siegellackschicht handelt. Auf der Heiß-Siegellackschicht 49 befinden sich eine Leiterbahnstruktur und Kontaktflächen sowie Bauelemente 25, bei denen es sich vorzugsweise um Leuchtdioden (LED) 21, 22, 23, 24 und 25 handelt (siehe Fig. 7).

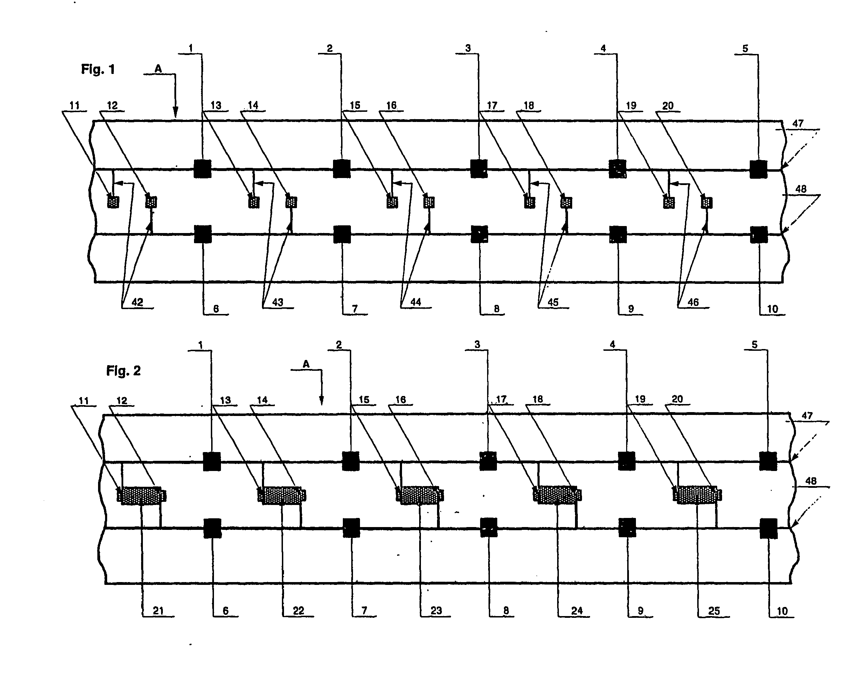

Bei der dargestellten Ausführungsform umfasst die Leiterbahnstruktur zwei in der Längsrichtung der bahnförmigen Anordnung verlaufende, in Querrichtung voneinander beabstandete, gemeinsame Leiterbahnen 47 und 48 und individuelle Leiterbahnen 42, 43, 44, 45, 46, die zu Kontaktflächen 11 bis 20 (vgl. Fig. 1) für die Bauteile 21 bis 25 (vgl. Fig. 2, 4) in der ersichtlichen Weise führen. In der Längsrichtung gesehen, weist jede gemeinsame Leiterbahn 47, 48 Kontaktflächen 1 bis 10 auf, wobei sich jeweils zwischen zwei Bauelementen 21 bis 25 angeordnete Kontaktflächen 11 bis 20 in der ersichtlichen Weise vorzugsweise mittig in Querrichtung gegenüberliegen. Beispielsweise liegen sich zwischen den Bauelementen 21 und 22 die Kontaktflächen 1 und 6 der gemeinsamen Leiterbahnen 47 und 48 gegenüber. Über diese Kontaktflächen 1 bis 10 wird in der später näher erläuterten Weise Strom zu den gemeinsamen Leiterbahnen 47 und 48 zugeführt.

Zwischen jeweils zwei Kontaktflächen 11 bis 20 ist gemäß Figur 4 ein Bauelement 21, 22, 23, 24 bzw. 25 angeordnet und elektrisch mit den entsprechenden Kontaktflächen 1 bis 10 verbunden, so dass bei der Stromversorgung über die gemeinsamen Leitungen 47 und 48 die Bauelemente 21 bis 25 zum Leuchten gebracht werden.

Das Abdeckteil 26 ist so auf der bisher beschriebenen Anordnung aufgebracht, dass in dem Abdeckteil 26 angeordnete Aussparungen 27 bis 36 deckungsgleich zu den Kontaktflächen 1 bis 10 angeordnet sind, und dass die in dem Abdeckteil 26 angeordneten muldenförmigen Kavitäten 37 bis 41 deckungsgleich zu den Bauelementen 21 bis 25 angeordnet sind.

Wie insbesondere aus den Figuren 6 und 7 ersichtlich, überdeckt das Abdeckteil 53 die Aussparungen 27 bis 36 und die darin angeordneten Kontaktflächen 1 bis 10, so dass von außen keine Feuchtigkeit eindringen kann. Gemäß Figur 7 weist die Abdeckschicht 53 vorzugsweise die Form einer sich in Längsrichtung der bandförmigen Anordnung beidseitig der Bauelemente 21 bis 25 erstreckenden streifenförmigen Schicht auf, die die Aussparungen 27 bis 36 wasserdicht verschließt.

Gemäß Figur 7 ist aus der bandförmigen Anordnung eine die Bauelemente 22 bis 25 umfassende Einheit herausgeschnitten, deren Kontaktflächen 4 und 9 zur Stromzufuhr freigelegt und in einer Einspeiseeinrichtung 54 angeordnet sind, in der Kontakte zwischen den Kontaktflächen 4 und 9 und den Leitungen eines Kabels 55 hergestellt werden. Das Kabel 55 ist vorzugsweise zur Stromeinspeisung mit einem Netzteil 56 verbunden.

Die bislang beschriebene bandförmige Anordnung wird in der folgenden Weise hergestellt. Auf den bandförmigen Leiterbahnträger A wird die Leiterbahnstruktur, beispielsweise die Leiterbahnstruktur der Figur 1, die die gemeinsamen Leiterbahnen 47, 48, die individuellen Leiterbahnen 42 bis 46, die Kontaktflächen 1 bis 10 für die Stromzufuhr und die Kontaktflächen 11 bis 20 für die Bauelemente 21 bis 25 umfasst, aufgebracht, vorzugsweise aufgedruckt. Insbesondere besteht der Substratträger A aus der Aluminiumschicht 51 und der darauf aufgebrachten dielektrischen Schicht 50, wobei die genannte Leiterbahnstruktur auf die der Aluminiumschicht 51 abgewandten Seite der dielektrischen Schicht 50 aufgedruckt wird. Hierzu eignet sich insbesondere ein Tiefdruckverfahren, zweckmäßigerweise ein Rotationstiefdruckverfahren von Rolle zu Rolle, das eine extrem hohe Verarbeitungsgeschwindigkeit bei höchster Genauigkeit und extrem geringen Ausfallsquoten ermöglicht. In einem weiteren Arbeitsschritt wird gemäß Figur 2 die bandförmige Anordnung der Figur 1 mit den Bauelementen 21 bis 25, bei denen es sich vorzugsweise um lichtemittierende Dioden in der sogenannten SMD-Technik handelt, bestückt. Nachfolgend wird das Abdeckteil 26, bei der es sich vorzugsweise um eine PVC-Folie handelt, die die Kavitäten 37 bis 41 und die Aussparungen 27 bis 36 enthält, wobei die Kavitäten 37 bis 41 in einem Tiefziehverfahren eingebracht und die Aussparungen 27 bis 36 eingestanzt werden, zu der Anordnung der Figur 2 lageorientiert zugeführt und mit der Hilfe eines Siegelwerkzeuges mit der Anordnung der Figur 2 verbunden. Zu diesem Zweck ist auf der Anordnung der Figur 2 gemäß Figur 6 vorzugsweise eine Heiß-Siegellackschicht 49 aufgebracht, die durch Platten- oder Walzensiegelung zum Schmelzen gebracht und durch Aufbringen eines Anpressdruckes des Siegelwerkzeuges mit dem Abdeckteil 26 verbunden wird. Vorzugsweise werden sowohl die bandförmige Anordnung der Figur 2, wie auch das bandförmige Abdeckteil 26 der Figur 3 von entsprechenden Vorratsrollen abgewickelt und zur Versiegelung dem Siegelwerkzeug lageorientiert zugeführt. Bei der Verwendung eines die Aluminiumschicht 51 umfassenden Substratträgers A 50 (vgl. Fig. 2, 5, 15, 16) ist es vorteilhaft, dass das hoch wärmeleitfähige Aluminium den Heiß-Siegellack besonders schnell und gleichmäßig zum Schmelzen bringt. Es entsteht so die Anordnung der Figur 4.

Die Aussparungen 27 bis 36 werden dann durch Aufbringen der Abdeckschicht 53, bei der es sich vorzugsweise um streifenförmige, aufgesiegelte Klebebänder handelt, verschlossen, wobei die Anordnung der Figur 7 entsteht. Schließlich kann gemäß Figur 6 auf der den Bauelementen 21 bis 25 abgewandten Seite der Anordnung der Figur 7, d.h. also auf der Unterseite der Anordnung, eine Haftschicht 52 aufgebracht werden, bei der es sich um eine selbstklebende Schicht handeln kann, die mit einer nicht näher dargestellten, abziehbaren Schutzfolie versehen sein kann. Auf diese Weise kann die Anordnung nach einer entsprechenden Konfektionierung an Gegenständen oder Einrichtungen, beispielsweise an Wänden oder dergleichen verklebt werden.

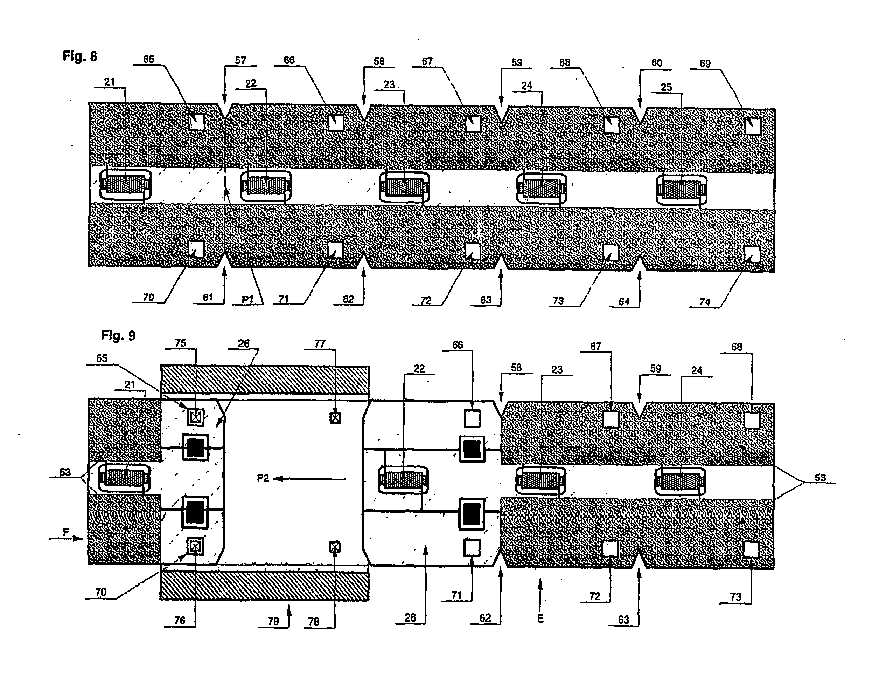

Im folgenden wird nun im Zusammenhang mit den Figuren 8 bis 12 eine Weiterbildung der Erfindung erläutert, bei der die bislang beschriebene bandförmige Anordnung gemäß den Figuren 6 und 7 durch einen Stanzvorgang eingebrachte Justieraussparungen 65 bis 74 und Ausschnitte 57 bis 64 aufweist, wobei jeweils ein sich vorzugsweise in Querrichtung gegenüberliegendes Paar (z.B. 65 und 70) von Justieraussparungen und ein Paar von sich ebenfalls in Querrichtung gegenüberliegenden Ausschnitten (beispielsweise 57 und 61) pro Abschnitt der bandförmigen Anordnung vorgesehen sind, wobei ein Abschnitt ein Bauelement (beispielsweise das Bauelement 21) und ein Kontaktflächenpaar (beispielsweise die Kontaktflächen 1 und 6, nicht sichtbar) umfasst. Vorzugsweise sind die sich gegenüberliegenden Ausschnitte 57, 61 bzw. 58, 62 bzw. 59, 63 bzw. 60, 64 dreieckförmig ausgebildet, wobei ihre sich gegenüberliegenden Spitzen durch eine optisch erkennbare Schnittlinie P1 verbunden sind, so dass ein Abschneiden entlang dieser Schnittlinie P1 mit einem geeigneten Schneidewerkzeug ohne weiteres möglich ist. Durch Schneiden entlang der Schnittlinie P1 kann die bandförmige Anordnung einfach in die je nach Anwendungsfall geeigneten Längen unterteilt werden.

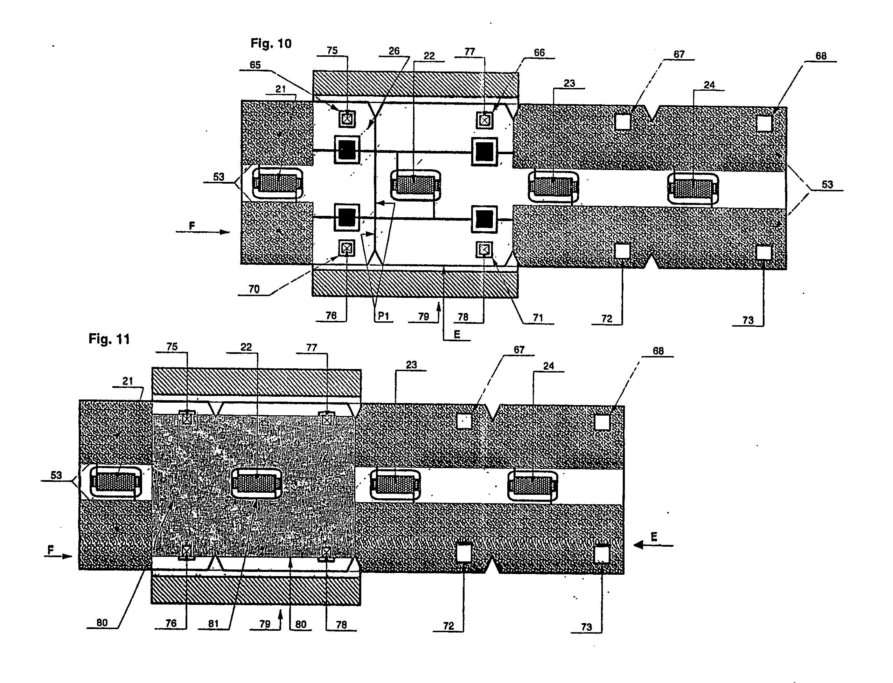

Es ist auch denkbar, einen zwischen zwei Paaren von Ausschnitten, beispielsweise zwischen den Ausschnitten 57 und 61 und den Ausschnitten 58 und 62 liegenden Ausschnitt gemäß Figur 9 aus der bandförmigen Anordnung herauszuschneiden, wenn dieser beispielsweise schadhaft geworden ist. Zur Verbindung der verbleibenden Teile der bandförmigen Anordnung werden die einander zugewandten Abschnitte F und E in einer Fixierlehre 79 (Figur 9) angeordnet, wobei die Fixierlehre 79 zu diesem Zweck Justierzapfen 75 bis 78 aufweist, von denen sich jeweils zwei Justierzapfen 75 und 76 bzw. 77 und 78 in Querrichtung gegenüberliegen und entsprechend dem Rastermaß des Abstandes der Justieraussparungen 65 bis 74 in der Längsrichtung voneinander beabstandet sind. Zur Verbindung zweier Abschnitte F und E der bandförmigen Anordnung wird ein erster Abschnitt F in die Fixierlehre 79 derart eingelegt, dass die Justierzapfen 75 und 76 in die Justieraussparungen 65 und 70 eingreifen. Entsprechend wird ein mit dem Abschnitt F zu verbindender Abschnitt E in die Fixierlehre 79 derart eingelegt und verschoben (Pfeil P2), dass die Justierzapfen 77 und 78 die Justieraussparungen 67 und 72 (in Figur 9 nicht sichtbar) durchgreifen. In diesem Zustand stoßen dann die Abschnitte F und E mit ihren Schnittlinien P1 aneinander, wie dies in der Figur 10 dargestellt ist.

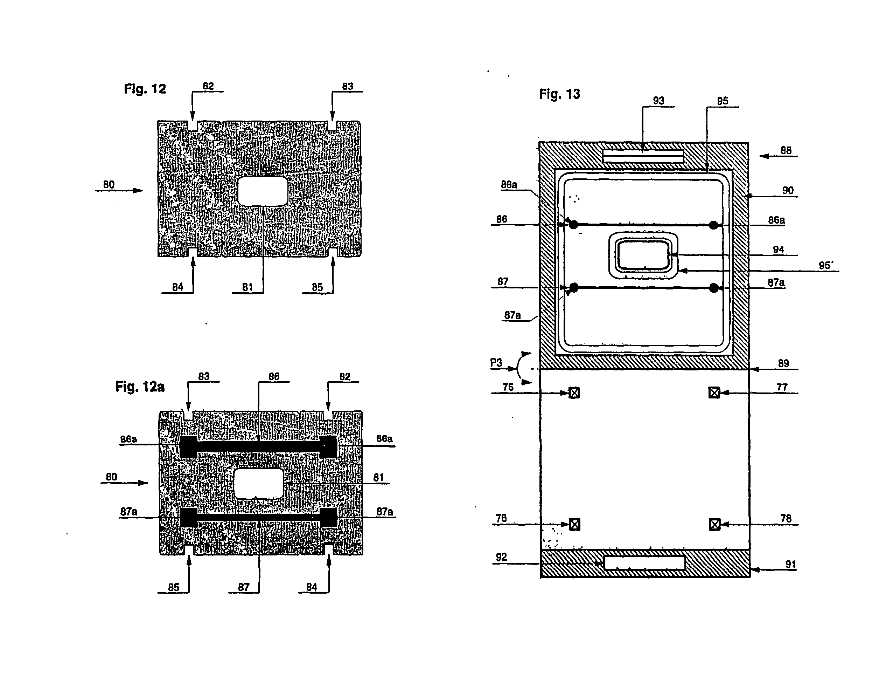

Es wird nun eine in den Figuren 12 und 12a dargestellte Kontaktbrücke 80 in die Fixierlehre 79 gemäß Figur 11 eingelegt. Dabei zeigt die Figur 12 die Außenseite der Kontaktbrücke 80 und Figur 12a zeigt die Innenseite derselben. An der Innenseite weist die Kontaktbrücke 80 den gemeinsamen Leiterbahnen 47, 48 entsprechende Brückenkontakte 86, 87 auf, die an ihren Endbereichen den Kontaktflächen der zu verbindenden Abschnitte F und E entsprechende Kontaktflecken 86a und 87a besitzen. Um die Kontaktbrücke 80 in der richtigen Lage in der Fixierlehre 79 positionieren zu können, in der es die elektrische Verbindung zwischen den Kontaktflächen der Abschnitte F und E herstellt, weist diese als Justierhilfe Aussparungen 82 bis 85 auf, die beim Einlegen der Justierbrücke 80 in die Fixierlehre 79 zu den Justierzapfen 75 bis 78 ausgerichtet werden, derart, dass diese die Aussparungen 83 bis 84 durchgreifen. Die Figur 11 zeigt diese Position des Brückenteiles 80. Beim Aufbringen und Verbinden der Kontaktbrücke 80 mit den Abschnitten E und F beaufschlagen die Brückenkontakte 86, 87 mit ihren Kontaktflecken 86a bzw. 87a die Kontaktflächen der Abschnitte E und F. Es wird so eine dauerhafte elektrische Verbindung der Abschnitte E und F sichergestellt. Bei dem Brückenteil 80 handelt es sich vorzugsweise um ein Folienteil, auf das die Brückenkontakte 86, 87 aufgedruckt sind. Nach dem Verbinden der Abschnitte F und E miteinander kann die Anordnung aus der Fixierlehre 79 entnommen werden. Die Kontaktbrücke 80 weist eine Aussparung 81 auf, durch die ein Bauelement hindurchtreten kann.

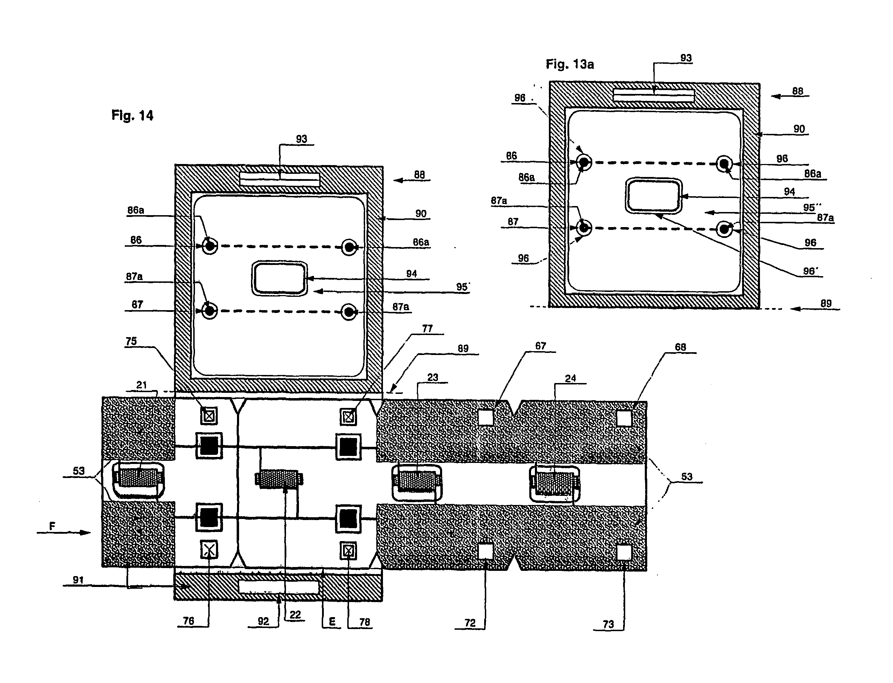

Die Figuren 13 und 14 zeigen ein Kontaktclipteil 88, das ebenfalls dazu dient, Abschnitte F und E der bandförmigen Anordnung miteinander zu verbinden bzw. aneinander zu halten, wobei das Kontaktclipteil 88 dauerhaft mit diesen Abschnitten E und F verbunden wird. Das Kontaktclipteil 88 besteht aus einem Oberteil 90 und einem Unterteil 91, wobei das Unterteil 91 im wesentlichen der bereits im Zusammenhang mit den Figuren 9 bis 12 beschriebenen Fixierlehre 79 entspricht. Das Oberteil 90 ist entlang einer Drehachse 89, die in Längsrichtung der aneinander zu fügenden Abschnitte F und E verläuft, quer zur Längslinie an das Unterteil 91 angesetzt, so dass es um die Drehachse 89 verschwenkbar und deckungsgleich über dem Unterteil 91 anordenbar ist. Im Unterteil 91 sind die Justierzapfen 75 bis 78 angeordnet. Das Unterteil 91 und das Oberteil 90 weisen eine Verriegelungseinrichtung auf, mit deren Hilfe das auf das Unterteil 91 geklappte Oberteil 90 am Unterteil 91 so verriegelbar ist, dass es einen Pressdruck auf das Unterteil 91 ausübt. Vorzugsweise be sitzt die Verriegelungseinrichtung einen Gehäusedurchbruch 92 mit einer Verriegelungsschulter, welcher an der in Querrichtung gegenüberliegenden Seite der Drehachse 89 des Unterteiles 91 seitlich der Abschnitte F und E angeordnet ist, und in den eine Rastnase 93 des Oberteiles 90 an der Verriegelungsschulter einrastet, wenn das Oberteil 90 auf das Unterteil 91 geklappt ist. Es wird darauf hingewiesen, dass der Gehäusedurchbruch 92 auch am Oberteil 90 und die Rastnase am Unterteil 91 vorgesehen sein können.

Im Oberteil 90 sind die Brückenkontakte 86 und 87 mit den Kontaktflecken 86a und 87a an der dem Unterteil 91 zugewandten Seite angeordnet. Außerdem ist im. Oberteil 90 eine Aussparung 94 vorgesehen, durch die beim Schließen des Oberteiles 90 und des Unterteiles 91 das Bauteil 22 des Abschnittes E hindurchtreten kann. Um eine Abdichtung nach außen zu erreichen, wenn das Oberteil 90 und das Unterteil 91 aneinander verriegelt sind, sind im Oberteil 90 Dichtringe 95, 95' angeordnet, wobei ein Dichtring 95' die Aussparung 94 umgibt und der andere Dichtring 95 vorzugsweise außerhalb der Justierzapfen 75 bis 78 verläuft. Auf diese Weise wird im geschlossenen Zustand des Oberteiles 90 und des Unterteiles 91 erreicht, dass die zwischen den Dichtringen 95 und 95' liegenden Bereiche der Abschnitte F und E, insbesondere deren Kontaktflächen und deren Bauelemente nach außen abgedichtet sind-Die Figur 13a zeigt eine Ausführungsform, bei der anstelle der zuvor beschriebenen Dichtringe ein Dichtplättchen 95" vorgesehen ist, das der Aussparung 94 und den Kontaktflecken 86a und 87a entsprechende Ausschnitte 96 bzw. 96' aufweist.

Die Figur 14 zeigt die in dem Unterteil 91 des Kontaktclipteiles 88 angeordneten Abschnitte F und E vor dem Schließen des Kontaktclipteiles 88 (Pfeil P3 in Figur 13).

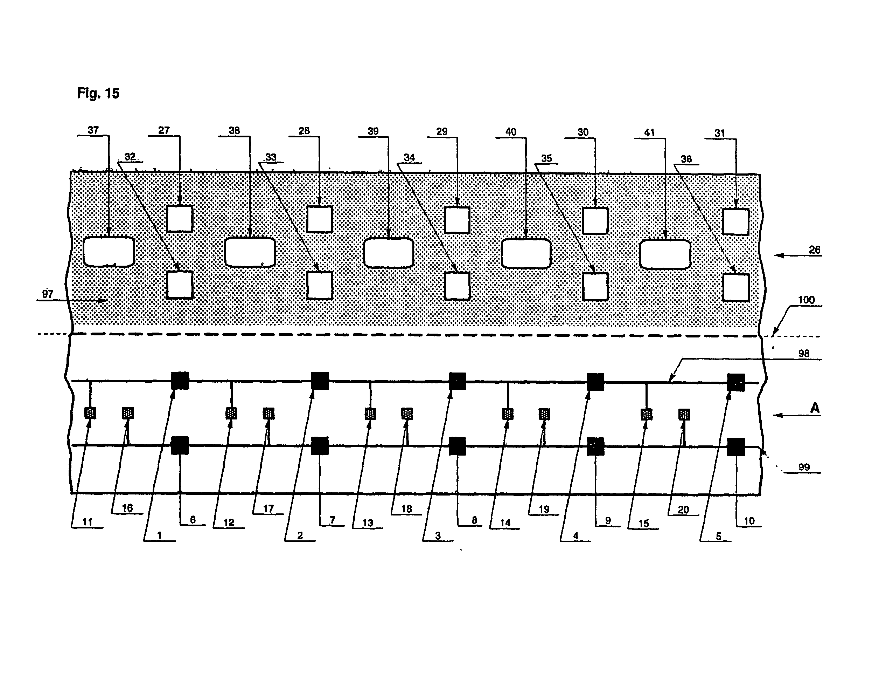

Die Figur 15 zeigt eine besonders bevorzugte Ausgestaltung der Erfindung, bei der das im Zusammenhang mit der Figur 3 bereits erläuterte bandförmige Abdeckteil 26 und der im Zusammenhang mit der Figur 1 bereits erläuterte bandförmige Leiterbahnträger A einstückig, vorzugsweise aus einem Kunststoffmaterial hergestellt ist und um eine Biegelinie 100 in Längsrichtung faltbar miteinander verbunden sind. Das Abdeckteil 26 weist an seiner dem Leiterbahnträger A zugewandten Seite vorzugsweise eine ganzflächig aufgetragene Klebstoffschicht 97 auf. Die Leiterbahnstruktur ist auf die Oberfläche des Substratträgers A vorzugsweise aufgedruckt.

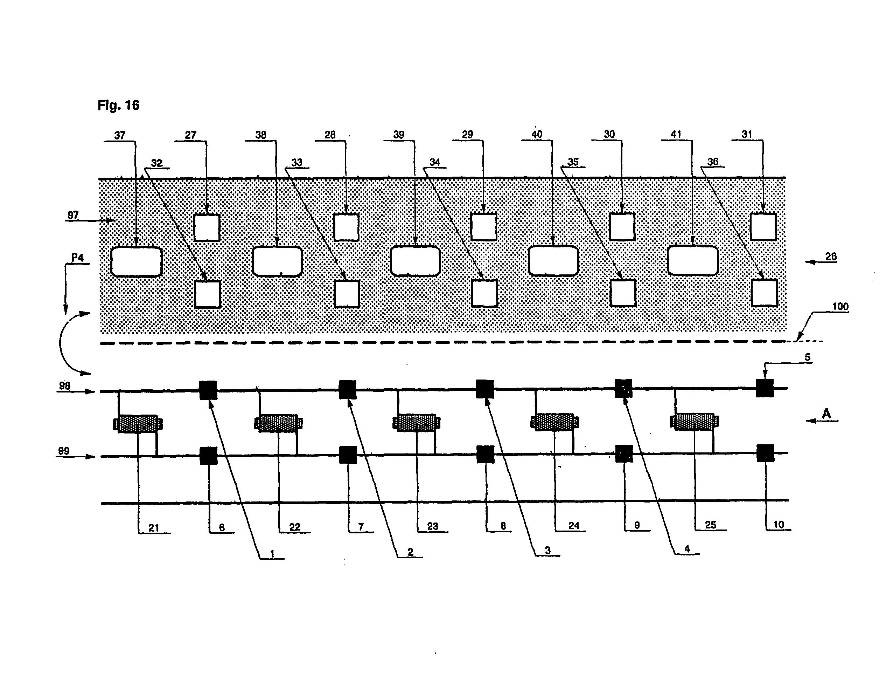

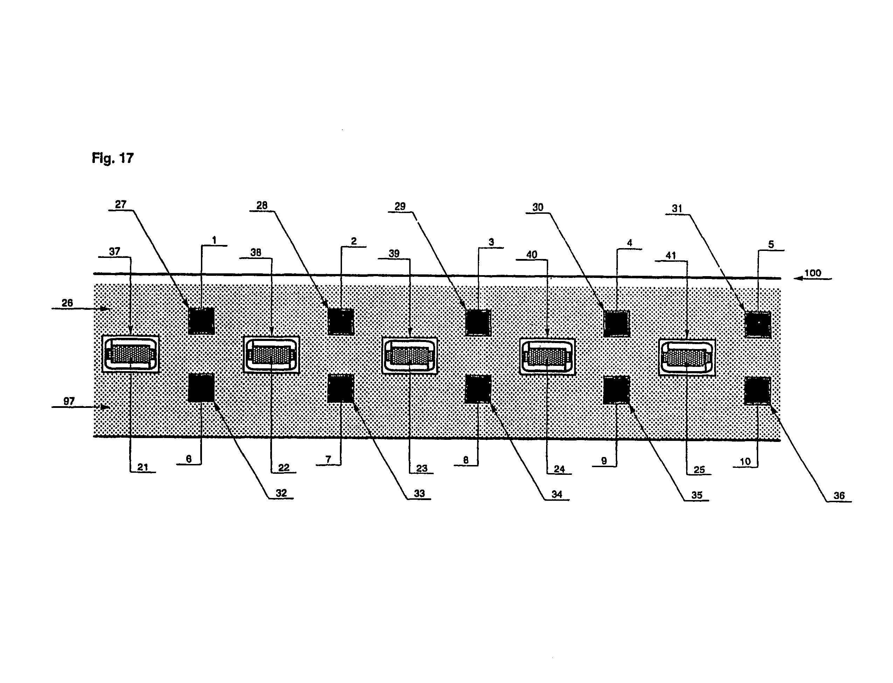

Die Figur 16 zeigt die Anordnung der Figur 15, wobei jedoch der Leiterbahnträger A mit den Bauelementen 21 bis 25 in der im Zusammenhang mit der Figur 2 beschriebenen Weise bestückt ist. Zur Herstellung der fertigen bandförmigen Anordnung werden das Abdeckteil 26 und der Leiterbahnträger A um die Biegelinie 100 gefaltet und, wie dies in der Figur 16 durch den Pfeil P4 gezeigt ist, deckungsgleich aufeinander geklappt, so dass die in der Figur 17 dargestellte bandförmige Anordnung entsteht, wobei die Bauelemente 21 bis 25 in die Kavitäten 37 bis 41 der Abdeckteil 26 eintauchen. Durch eine Druckbeaufschlagung werden das Abdeckteil 26 und der darunter befindliche Leiterbahnträger A mittels der Klebstoffschicht 97 dauerhaft und wasserdicht miteinander verbunden.

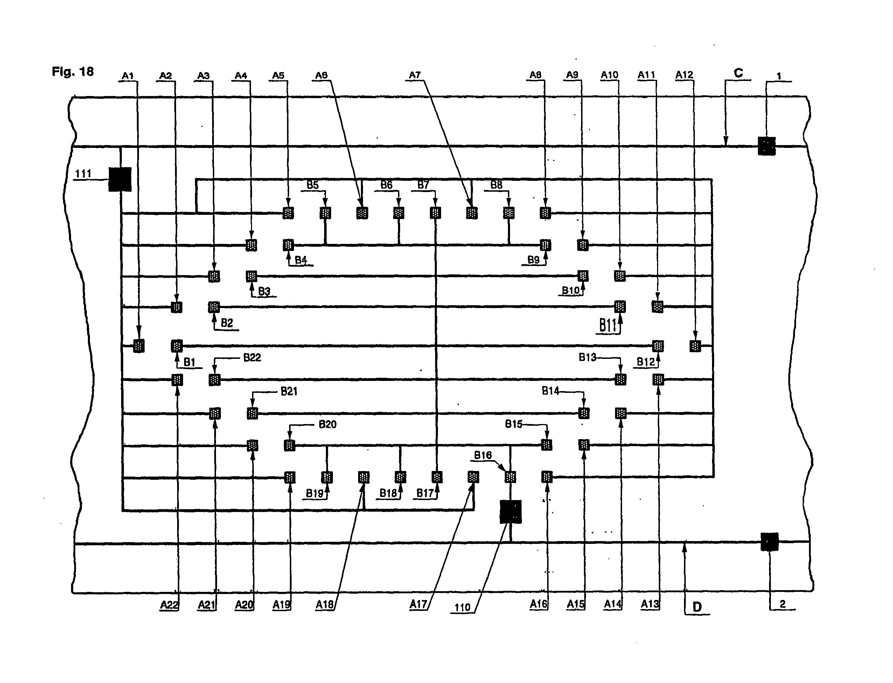

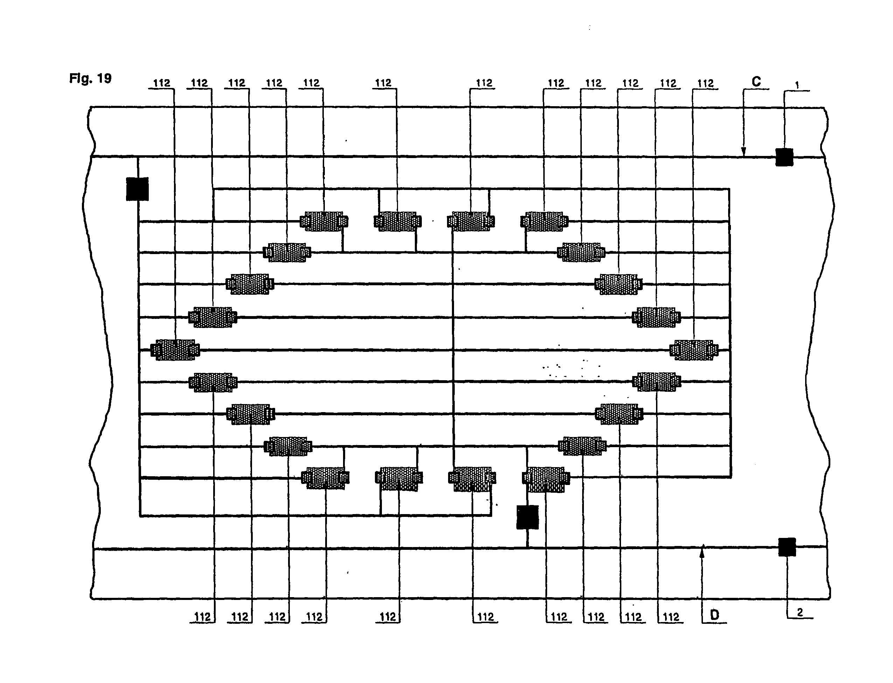

Im folgenden werden im Zusammenhang mit den Figuren 18 bis 21 Ausführungsbeispiele gezeigt, bei denen Leuchtelemente 112 und die entsprechenden Kontaktflächen A1 bis A22 und B1 bis B22 eines Abschnittes der bandförmigen Anordnung zur Ausübung einer besonderen Hinweisfunktion so angeordnet sind, dass in Längsrichtung gesehen nach beiden Seiten ein pfeilartiger Eindruck vermittelt wird. Die Leiterbahnstruktur ist entsprechend ausgebildet und weist für die Kontaktflächen B1 bis B22 eine gemeinsame Leiterbahn D und für die Kontaktflächen A1 bis A22 eine gemeinsame Leiterbahn C auf. Die individuellen Leiterbahnen sind der Einfachheit halber nicht näher bezeichnet. Die Kontaktflächen für die Stromzufuhr zu den gemeinsamen Leiterbahnen C und D sind wieder mit 1 und 2 bezeichnet. In der ersichtlichen Weise ist jeder Gruppe der Leuchtelemente ein Vorwiderstand 110 bzw. 111 zugeordnet. Die Figur 19 zeigt die an den Kontaktflächen A1 bis A22 und B1 bis B22 befestigten bzw. verklebten Leuchtelemente 112.

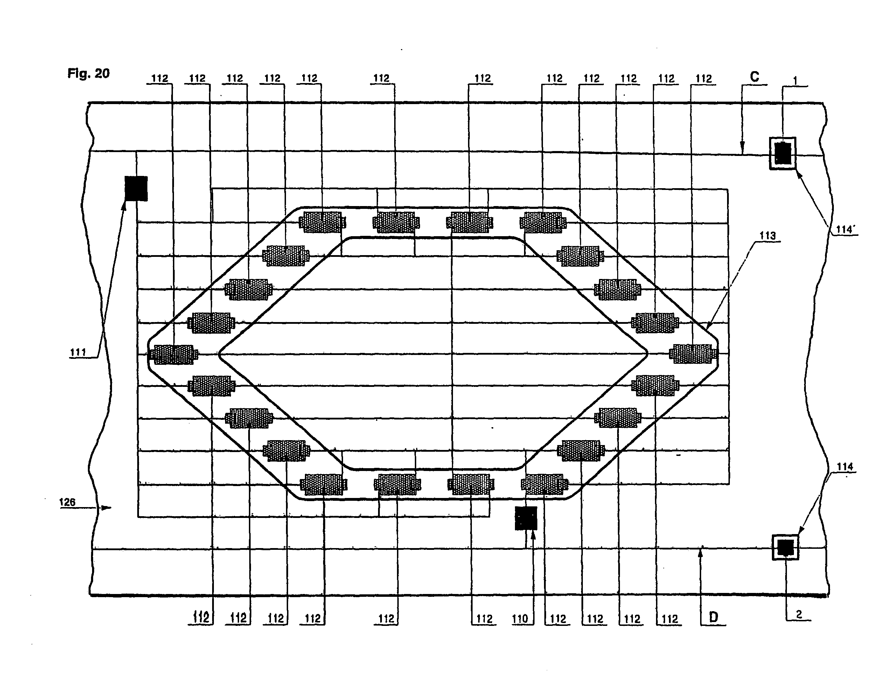

Die Figur 20 zeigt die Anordnung der Figur 19, wobei das Abdeckteil 26 aufgebracht ist, das besonders bevorzugt für alle Bauelemente 112 gemeinsam eine Kavität 113 und die Aussparungen 114 und 114' für die Kontaktflächen 1 und 2 aufweist. Es ist jedoch auch denkbar, dass das Abdeckteil 126 für jedes Leuchtelement 112 eine eigene Kavität aufweist.

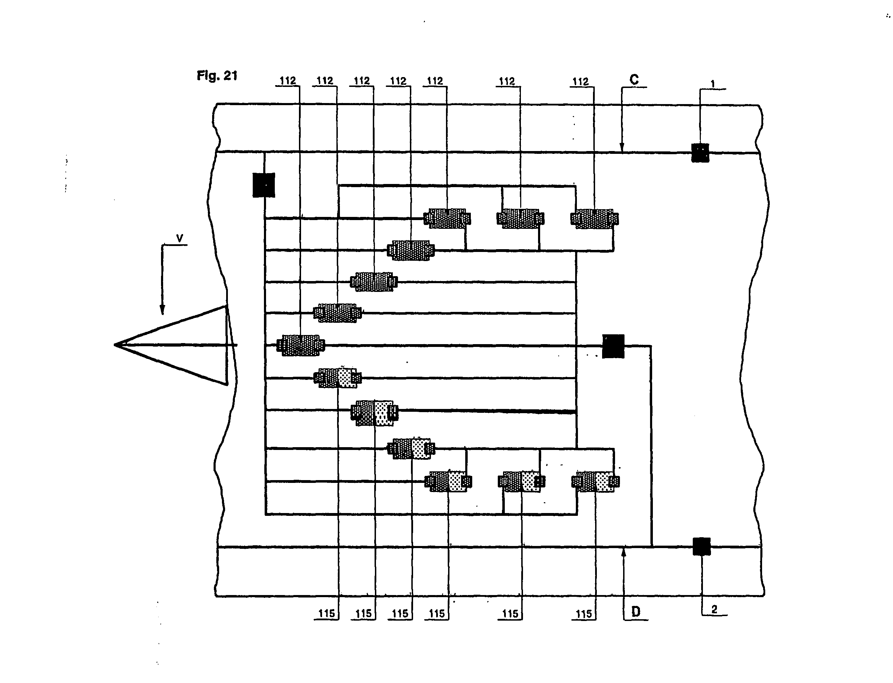

Die Figur 21 zeigt ein weiteres Ausführungsbeispiel, bei dem zumindest einfarbige Leuchtelemente 112 und zweifarbige Leuchtelemente 115 vorgesehen sind. Mit dieser Anordnung lässt sich erreichen, dass ein Betrachter dann, wenn er in Richtung des Pfeils V blickt, die rechte Seite der zweifarbigen Leuchtelemente 115 in einer Farbe, beispielsweise "Grün", wahrnimmt und die linke Seite der zweifarbigen Leuchtelemente 115 in einer anderen Farbe, beispielsweise "Rot", wahrnimmt, wenn er entgegen der Pfeilrichtung V blickt. Auf diese Weise kann ein Fußgänger erkennen, dass er beim Gehen in der richtigen Laufrichtung die Farbe "Grün" sieht und beim Gehen in der falschen Laufrichtung die Farbe "Rot" erblickt. Diese Anordnung ist daher als Leitsystem besonders vorteilhaft einsetzbar. Es ist denkbar die einfarbigen und zweifarbigen Leuchtelemente 112, 115 in beliebiger Weise, je nach Anforderung, vorzusehen. Auch sind Anordnungen denkbar, die nur zweifarbige Leuchtelemente umfassen.

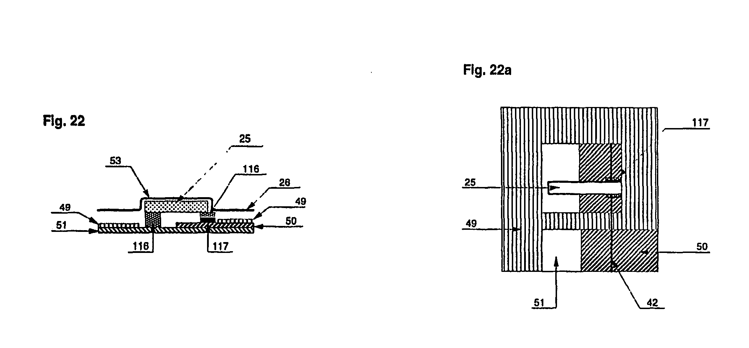

Schließlich wird im Zusammenhang mit den Figuren 22 und 22a eine weitere besonders vorteilhafte Ausführungsform der vorliegenden Erfindung erläutert, bei der der Leiterbahnträger A eine elektrisch leitende Schicht, vorzugsweise die Aluminiumschicht 51, aufweist und die als eine gemeinsame Leiterbahn verwendet wird. In diesem Fall können die einen Anschlüsse der Bauelemente 25 in ihrer Gesamtheit jeweils über eine Kontaktfläche 116, die vorzugsweise die Form eines Leitkleberpunktes aufweist und in einer Aussparung 118 der auf der Aluminiumschicht 51 angeordneten dielektrischen Schicht 50 vorgesehen ist, mit der Aluminiumschicht 51 verbunden sein, während die anderen Anschlüsse des Bauelementes 25 jeweils mit einer individuellen Kontaktfläche 117 verbunden sind, die auf der dielektrischen Schicht 50 angeordnet ist. In diesem Fall ersetzt die Aluminiumschicht 51 eine gemeinsame Leiterbahn. Die Heiß-Siegellackschicht 49 befindet sich auf Teilbereichen der zum Abdeckteil 26 hin freiliegenden Seite der Aluminiumschicht 51 sowie zum Abdeckteil 26 hin freiliegende Bereiche der dielektrischen Schicht 50, derart, dass zumindest das Bauelement 25 vollständig von der Heiß-Siegellackschicht 49 umgeben ist und nach dem Verbinden des Leiterbahnträgers A mit dem Abdeckteil 26 vollständig wasserdicht eingeschlossen ist.

Die zuvor beschriebene Ausführungsform hat den Vorteil, dass ihre Leiterbahnstruktur wegen der Ausnutzung der Leitfähigkeit der Aluminiumschicht 51 als gemeinsame Leiterbahn besonders einfach ausgestaltet sein kann.

### Bezugszeichenliste

- A: Leiterbahnträger
- 1, 2, 3, 4, 5, 6,7,8,9,10: Kontaktfläche
- 11, 12, 13, 14, 15, 16,17,18,19,20: Kontaktfläche
- 21,22,23,24,25: Bauelement
- 26: Abdeckteil
- 27,28,29,30,31, 32, 33, 34, 35, 36,: Aussparung
- 37, 38, 39, 40, 41: Kavität
- 42, 43, 44, 45, 46: individuelle Leiterbahn
- 47,48: gemeinsame Leiterbahn
- 49: Heiß-Siegellackschicht
- 50: dielektrische Schicht
- 51: Aluminiumschicht
- 52: Haftschicht
- 53: Abdeckschicht
- 54: Einspeisungseinrichtung
- 55: Kabel
- 56: Netzteil
- 57, 58, 59, 60, 61,62,63,64: Ausschnitt
- 65, 66, 67, 68, 69, 70,71,72,73,74: Justierau ssparung
- P1: Schnittlinie
- P2: Pfeil
- E, F: Abschnitt
- 75,76,77,78: Justierzapfen
- 79: Fixierleh re
- 80: Kontaktbrücke
- 81: Aussparung
- 82, 83, 84, 85: Aussparung
- 86,87: Brückenkontakt
- 86a,87a: Kontaktflecken
- 88: Kontaktclipteil
- 89: Drehachse
- 90: Oberteil
- 91: Unterteil
- 92: Gehäusedurchbruch
- 93: Rastnase
- 94: Aussparung
- 95, 95': Dichtring
- 95": Dichtplättchen
- 96,96': Ausschnitt
- P3: Pfeil
- 97: Klebstoffschicht
- 98,99: gemeinsame Leiterbahn
- 100: Biegelinie
- P4: Pfeil
- 110, 111: Vorwiderstand
- 112: Leuchtelement
- 113: Kavität
- 114,114': Aussparung
- 115: zweifarbiges Leuchtelement
- 116: Leitkleber
- 117: individueller Kontakt
- 118: Aussparung
- 126: Abdeckschicht
- A1 - A22: Kontaktfläche
- B1 - B22: Kontaktfläche
- C: gemeinsame Leiterbahn
- D: gemeinsame Leiterbahn

## Patentansprüche

1. Bandförmige Anordnung mit einer Leiterbahnstruktur (A) und mit dieser elektrisch verbundenen elektronischen Bauelementen (21 bis 25), insbesondere Lichtbahn mit Leuchtelementen, wobei die Leiterbahnstruktur (A) und die Bauelemente (21 bis 25) auf einem Leiterbahnträger (A) angeordnet sind und wobei die Leiterbahnstruktur (A) Leiterbahnen (42 bis 48), Kontaktflächen (11 bis 20) für Bauelemente und Kontaktflächen (1 bis 10) für die Stromzufuhr umfasst, **gekennzeichnet durch** ein Abdeckteil (26), das Kavitäten (37 bis 41) und Aussparungen (27 bis 36) aufweist und derart dicht mit dem Leiterbahnträger (A) verbunden und auf diesem angeordnet ist, dass die Bauelemente (21 bis 25) in die Kavitäten (37 bis 41) eingreifen und dass die Kontaktflächen (1 bis 10) für die Stromzufuhr in den Aussparungen (27 bis 36) des Abdeckteils (26) angeordnet sind, und **durch** eine die nicht zur Stromzufuhr herangezogenen Kontaktflächen (1 bis 10) für die Stromzufuhr dicht überdeckende Abdeckschicht (53).

2. Bandförmige Anordnung nach Anspruch 1, **dadurch gekennzeichnet, dass** der Leiterbahnträger (A) eine elektrisch leitende Schicht und eine darauf aufgebrachte dielektrische Schicht (50) umfasst, dass auf der dielektrischen Schicht (50) eine die dielektrische Schicht (50) mit dem Abdeckteil (26) dicht verbindende Schicht (49) angeordnet ist, und dass auf der dem Abdeckteil (26) zugewandten Seite der dielektrischen Schicht (50) die Leiterbahnstruktur (A) und die Bauelemente (21 bis 25) angeordnet sind.

3. Bandförmige Anordnung nach Anspruch 2, **dadurch gekennzeichnet, dass** die elektrisch leitende Schicht eine Aluminiumschicht (51) ist.

4. Bandförmige Anordnung nach Anspruch 2 oder 3, **dadurch gekennzeichnet, dass** die das Abdeckteil (26) dicht mit der dielektrischen Schicht (50) verbindende Schicht eine Siegellackschicht (49), vorzugsweise eine Heiß-Siegellackschicht ist.

5. Bandförmige Anordnung nach einem der Ansprüche 1 bis 4, **dadurch gekennzeichnet, dass** der Leiterbahnträger (A) an der der Abdeckschicht (26) abgewandten Seite eine Haftschicht (52) aufweist, mit der der Leiterbahnträger (A) an einem Gegenstand verklebbar ist.

6. Bandförmige Anordnung nach Anspruch 5, **dadurch gekennzeichnet, dass** die Haftschicht (52) eine an ihrer dem Abdeckteil (26) abgewandten Seite mit einer abziehbaren Schutzfolie versehene Klebstoffschicht ist.

7. Bandförmige Anordnung nach einem der Ansprüche 1 bis 6, **dadurch gekennzeichnet, dass** das Abdeckteil (26) ein Kunststoffteil ist, in dem die Kavitäten (37 bis 41) durch Tiefziehen hergestellt sind.

8. Bandförmige Anordnung nach einem der Ansprüche 1 bis 7, **dadurch gekennzeichnet, dass** das Abdeckteil (26) ein Kunststoffteil ist, in dem die Aussparungen (27 bis 36) durch Stanzen hergestellt sind.

9. Bandförmige Anordnung nach einem der Ansprüche 1 bis 8, **dadurch gekennzeichnet, dass** das Abdeckteil (26) aus einem Kunststoffmaterial, vorzugsweise PVC besteht.

10. Bandförmige Anordnung nach einem der Ansprüche 1 bis 9, **dadurch gekennzeichnet, dass** die Leiterbahnstruktur (A) eine erste in der Längsrichtung der Anordnung verlaufende gemeinsame Leiterbahn (47) für die Stromversorgung und eine zweite in der Längsrichtung verlaufende gemeinsame Leiterbahn (48) für die Stromversorgung aufweist, dass die erste und die zweite Leiterbahn in Querrichtung voneinander beabstandet sind, dass die erste gemeinsame Leiterbahn (47) in der Längsrichtung voneinander beabstandete erste Kontaktflächen (1 bis 5) für die Stromzufuhr und die zweite gemeinsame Leiterbahn (48) in der Längsrichtung voneinander beabstandete zweite Kontaktflächen (6 bis 10) für die Stromzufuhr aufweist, wobei die ersten Kontaktflächen (1 bis 5) für die Stromzufuhr und die zweiten Kontaktflächen (6 bis 10) für die Stromzufuhr sich vorzugsweise jeweils paarweise in der Querrichtung gegenüber liegen, dass die Leiterbahnstruktur (A) ferner erste und zweite individuelle Leiterbahnen (42 bis 46) aufweist, wobei die ersten individuellen Leiterbahnen ausgehend von der ersten Leiterbahn (47) für die Stromzufuhr zu ersten Kontaktflächen (11, 13, 15, 17, 19) für Bauelemente und die zweiten individuellen Leiterbahnen ausgehend von der zweiten gemeinsamen Leiterbahn (48) zu zweiten Kontaktflächen (12, 14, 16, 18, 20) für Bauelemente verlaufen, wobei zwischen jeweils einer ersten Kontaktfläche für Bauelemente und einer zugeordneten zweiten Kontaktfläche für Bauelemente ein Bauelement (21 bis 25) angeordnet ist.

11. Bandförmige Anordnung nach einem der Ansprüche 1 bis 10, **dadurch gekennzeichnet, dass** das Abdeckteil (26) entlang einer in Längsrichtung verlaufenden Biegelinie (100) mit dem Leiterbahnträger (A) verbunden und um die Biegelinie (100) deckungsgleich auf den Leiterbahnträger (A) gefaltet und mit diesem dicht verbunden ist.

12. Bandförmige Anordnung nach Anspruch 11, **dadurch gekennzeichnet, dass** das Abdeckteil (26) an seiner dem Leiterbahnträger (A) zugewandten Seite mit einer Schicht (97) zur dichten Verbindung des Abdeckteiles (26) mit dem Leiterbahnträger (A) versehen ist.

13. Bandförmige Anordnung nach Anspruch 12, **dadurch gekennzeichnet, dass** die Schicht (97) eine Klebstoffschicht ist.

14. Bandförmige Anordnung nach einem der Ansprüche 1 bis 13, **dadurch gekennzeichnet, dass** sie durch in der Längsrichtung voneinander beabstandete, sich in Querrichtung erstreckende Schnittlinien (P1) in gleiche Abschnitte unterteilt ist, wobei jeweils ein Abschnitt wenigstens ein Bauelement (21) und zwei Kontaktflächen (1, 6) für die Stromzufuhr aufweist.

15. Bandförmige Anordnung nach einem der Ansprüche 1 bis 14, **dadurch gekennzeichnet, dass** sie durch in der Längsrichtung voneinander beabstandete, sich in der Querrichtung gegenüberliegende, randseitige Ausschnitte (57 bis 64) in gleiche Abschnitte unterteilt ist, wobei jeweils ein Abschnitt wenigstens ein Bauelement (21) und zwei Kontaktflächen (1, 6) für die Stromzufuhr aufweist.

16. Bandförmige Anordnung nach Anspruch 15, **dadurch gekennzeichnet, dass** die Ausschnitte (57 bis 64) richtungsweisend, vorzugsweise dreieckförmig ausgebildet sind, wobei sich die Spitzen zweier gegenüberliegender Ausschnitte in Querrichtung gegenüberliegen.

17. Bandförmige Anordnung nach Ansprüchen 14 und 16, **dadurch gekennzeichnet, dass** die Spitzen zweier sich gegenüberliegender dreieckförmiger Ausschnitte (57, 61) auf einer Schnittlinie (P1) angeordnet sind.

18. Bandförmige Anordnung nach einem der Ansprüche 14 bis 17, **dadurch gekennzeichnet, dass** jeder Abschnitt (E, F) wenigstens zwei Justieraussparungen (65 bis 74) aufweist, die voneinander beabstandet sind und in entsprechende Justierzapfen (75 bis 78) einer Fixierlehre (79) einführbar sind, um zwei benachbarte, voneinander getrennte Abschnitte in der Fixierlehre (79) derart fixieren zu können, dass ihre einander zugewandten Endkanten in Querrichtung aneinander liegen, dass auf die in der Fixierlehre (79) angeordneten Bereiche der in der Fixierlehre (79) angeordneten Abschnitte (E, F) eine Kontaktbrücke (80) auflegbar ist, die an ihrer den Abschnitte (E, F) zugewandten Seite Brückenkontakte (86, 87) aufweist, die in Längsrichtung elektrische Verbindungen zwischen den gemeinsamen Leiterbahnen (47, 48) der Abschnitte (E, F) herstellen, wenn die Kontaktbrücke (80) an den Bereichen der Abschnitte (E, F) fixiert ist, und dass die Kontaktbrücke (80) als Justierhilfe Aussparungen (82 bis 85) aufweist, die den Justierzapfen (75 bis 78) entsprechend angeordnet sind.

19. Bandförmige Anordnung nach Anspruch 18, **dadurch gekennzeichnet, dass** den Endbereichen der Brückenkontakte (86, 87) den Kontaktflächen (1 bis 10) für die Stromzufuhr entsprechende Kontaktflecken (86a, 87a) angeordnet sind, die bei der Fixierung der Kontaktbrücke (80) auf Kontaktflächen (1 bis 10) für die Stromzufuhr zu liegen kommen.

20. Bandförmige Anordnung nach Anspruch 18 oder 19, **dadurch gekennzeichnet, dass** die Kontaktbrücke (80) die Form eines Kunststoffblättchens aufweist, auf dem die Brückenkontakte (86, 87) und gegebenenfalls die Kontaktflecken (86a, 87a) aufgebracht, vorzugsweise aufgedruckt sind, und dass die Kontaktbrücke (80) eine Aussparung (81) für ein Bauelement aufweist, das im fixierten Zustand der Kontaktbrücke (80) durch die Aussparung (81) der Kontaktbrücke (80) hindurch tritt.

21. Bandförmige Anordnung nach einem der Ansprüche 1 bis 20, **dadurch gekennzeichnet, dass** ein Kontaktclipteil (88) vorgesehen ist, das ein Oberteil (90) und ein Unterteil (91) umfasst, die entlang einer Drehachse (P3), vorzugsweise in Längsrichtung miteinander verbunden sind, derart, dass das Oberteil (90) um die Drehachse (89) deckungsgleich auf das Unterteil (91) faltbar ist, dass das Unterteil Justierzapfen (75 bis 78) aufweist, in die die Aussparungen (82 bis 85) zweier zu verbindenden Abschnitte (E, F) einlegbar sind, derart, dass die zu verbindenden Abschnitte (E, F) mit ihren in Querrichtung verlaufenden Endkanten aneinander liegen, dass das Oberteil (90) an seiner dem Unterteil (91) zugewandten Seite Brückenkontakte (86, 87) aufweist, die in der Längsrichtung elektrische Verbindungen der gemeinsamen Leiterbahnen (47, 48) herstellen, wenn die Abschnitte (E, F) zwischen dem Oberteil (90) und dem Unterteil (91) fixiert sind und dass das Oberteil (90) eine Aussparung (94) für das Bauelement eines Abschnittes (E) aufweist.

22. Bandförmige Anordnung nach Anspruch 21, **dadurch gekennzeichnet, dass** die Endbereiche der Brückenkontakte (86, 87) Kontaktflecken (86a, 87a) aufweisen, die an den individuellen Kontaktflächen (1 bis 10) für die Stromzufuhr der Abschnitte (E, F) zur Anlage gelangen, wenn das Oberteil an dem Unterteil (91) fixiert ist.

23. Bandförmige Anordnung nach Anspruch 24, **dadurch gekennzeichnet, dass** das Oberteil (90) und das Unterteil (91) durch eine Verriegelungseinrichtung aneinander befestigbar sind, wenn sie deckungsgleich aufeinander liegen.

24. Bandförmige Anordnung nach Anspruch 23, **dadurch gekennzeichnet, dass** die Verriegelungseinrichtung eine an der der Drehachse (89) in Querrichtung gegenüberliegenden Seite des Oberteils (90) oder des Unterteils (91) angeordnete Rastnase (93) aufweist, die in einen Gehäusedurchbruch (92) an der der Drehachse (89) in Querrichtung gegenüberliegenden Seite des Unterteils (91) oder des Oberteils (90) verrastend eingreift, wenn das Oberteil (90) und das Unterteil (91) deckungsgleich aufeinander liegen.

25. Bandförmige Anordnung nach einem der Ansprüche 21 bis 24, **dadurch gekennzeichnet, dass** ein erster Dichtungsring (95') vorgesehen ist, der die Aussparung (94) für ein Bauelement des Oberteils (90) an der dem Unterteil (91) zugewandten Seite umgibt, derart, dass eine Abdichtung eines durch die Aussparung (94) des Oberteils (90) hindurch ragenden Bauelementes bewirkt wird.

26. Bandförmige Anordnung nach einem der Ansprüche 21 bis 25, **dadurch gekennzeichnet, dass** ein zweiter Dichtungsring (95) vorgesehen ist, der die Brückenkontakte (86, 87) und gegebenenfalls die Kontaktflecken (86a, 87a) außenseitig umgibt und eine Abdichtung des von ihm umschlossenen Bereiches bewirkt, wenn das Oberteil an dem Unterteil (91) fixiert ist.

27. Bandförmige Anordnung nach einem der Ansprüche 1 bis 26, **dadurch gekennzeichnet, dass** mehrere Bauelemente (112) entsprechend dem Muster wenigstens eines in Längsrichtung weisenden Pfeils zwischen den gemeinsamen Leiterbahnen (C, D) eines Abschnittes angeordnet sind.

28. Bandförmige Anordnung nach Anspruch 27, **dadurch gekennzeichnet, dass** das Abdeckteil (26) jedem Bauelement (112) entsprechend eine eigene Kavität aufweist.

29. Bandförmige Anordnung nach Anspruch 27, **dadurch gekennzeichnet, dass** das Abdeckteil (26) eine für alle Bauelemente (112) eines Abschnittes gemeinsame Kavität (113) aufweist.

30. Bandförmige Anordnung nach einem der Ansprüche 1 bis 29, **dadurch gekennzeichnet, dass** die Bauelemente (112) die Form von lichtemittierenden Dioden aufweisen.

31. Bandförmige Anordnung nach Anspruch 30, **dadurch gekennzeichnet, dass** die lichtemittierenden Dioden einfarbig leuchtende Dioden sind.

32. Bandförmige Anordnung nach Anspruch 30, **dadurch gekennzeichnet, dass** die lichtemittierenden Dioden zumindest teilweise zweifarbig Leuchtende Dioden (115) sind, die so ausgerichtet sind, dass in der Längsrichtung gesehen von einer Seite her die eine Farbe und von der anderen Seite her die andere Farbe sichtbar ist.

33. Bandförmige Anordnung nach einem der Ansprüche 1 bis 32, **dadurch gekennzeichnet, dass** zwei sich gegenüber liegende Kontaktflächen (4, 9) für die Stromzufuhr in einer Einspeiseeinrichtung (54), die über ein Kabel (55) mit einem Netz verbindbar ist, zur Stromzufuhr zu den gemeinsamen Leiterbahnen (47, 48) eines Abschnittes kontaktierbar sind.

## Claims

1. Strip-type arrangement comprising a conductor structure (A) and electronic components (21 to 25) electrically connected thereto, in particular a luminous row with lighting elements, the conductor structure (A) and the components (21 to 25) being arranged on a conductor support (A) and the conductor structure (A) including conductors (42 to 48), contact surfaces (11 to 20) for components and contact surfaces (1 to 10) for the power supply, **characterised by** a covering part (26) having cavities (37 to 41) and recesses (27 to 36) and tightly connected to the conductor support (A) and arranged thereon in such a manner that the components (21 to 25) engage in the cavities (37 to 41) and that the contact surfaces (1 to 10) for the power supply are arranged in the recesses (27 to 36) in the covering part (26), and by a covering layer (53) tightly covering the contact surfaces (1 to 10) for the power supply not being used for the power supply.

2. Strip-type arrangement according to claim 1, **characterised in that** the conductor support (A) includes an electrically conductive layer and a dielectric layer (50) applied thereto, that a layer (49) tightly connecting the dielectric layer (50) to the covering part (26) is arranged on the dielectric layer (50) and that the conductor structure (A) and the components (21 to 25) are arranged on the side of the dielectric layer (50) directed towards the covering part (26).

3. Strip-type arrangement according to claim 2, **characterised in that** the electrically conductive layer is an aluminium layer (51).

4. Strip-type arrangement according to claim 2 or claim 3, **characterised in that** the layer tightly connecting the covering part (26) to the dielectric layer (50) is a sealing lacquer layer (49), preferably a heat-sealing lacquer layer.

5. Strip-type arrangement according to one of claims 1 to 4, **characterised in that** the conductor support (A) is provided on the side remote from the covering layer (26) with a bonding layer (52) by means of which the conductor support (A) can be bonded to an object.

6. Strip-type arrangement according to claim 5, **characterised in that** the bonding (52) is an adhesive layer provided on its side remove from the covering part (26) with a peel-off protective film.

7. Strip-type arrangement according to one of claims 1 to 6, **characterised in that** the covering part (26) is a plastic part in which the cavities (37 to 41) are produced by thermoforming.

8. Strip-type arrangement according to one of claims 1 to 7, **characterised in that** the covering part (26) is a plastic part in which the recesses (27 to 36) are produced by punching.

9. Strip-type arrangement according to one of claims 1 to 8, **characterised in that** the covering part (26) consists of a plastic material, preferably PVC.

10. Strip-type arrangement according to one of claims 1 to 9, **characterised in that** the conductor structure (A) has a first common conductor (47) for the power supply extending in the longitudinal direction of the arrangement and a second common conductor (48) for the power supply extending in the longitudinal direction, that the first and the second conductors are arranged at a distance from one another in the transverse direction, that the first common conductor (47) has first contact surfaces (1 to 5) for the power supply arranged at a distance from one another in the longitudinal direction and the second common conductor (48) has second contact surfaces (6 to 10) for the power supply arranged at a distance from one another in the longitudinal direction, the first contact surfaces (1 to 5) for the power supply and the second contact surfaces (6 to 10) for the power supply preferably being situated opposite one another in pairs in the transverse direction, that the conductor structure (A) furthermore has first and second individual conductors (42 to 46), the first individual conductors extending from the first conductor (47) for the power supply to first contact surfaces (11, 13, 15, 17, 19) for components and the second individual conductors extending from the second common conductor (48) to second contact surfaces (12, 14, 16, 18, 20) for components, one component (21 to 25) being arranged between each first contact surface for components and an associated second contact surface for components.

11. Strip-type arrangement according to one of claims 1 to 10, **characterised in that** the covering part (26) is connected to the conductor support (A) along a bending line (100) extending in the longitudinal direction and is folded about the bending line (100) congruently on to the conductor support (A) and is tightly connected thereto.

12. Strip-type arrangement according to claim 11, **characterised in that** the covering part (26) is provided on its side directed towards the conductor support (A) with a layer (97) for tightly connecting the covering part (26) to the conductor support (A).

13. Strip-type arrangement according to claim 12, **characterised in that** the layer (97) is an adhesive layer.

14. Strip-type arrangement according to one of claims 1 to 13, **characterised in that** it is divided into equal sections by cutting lines (P1) extending in the transverse direction and arranged at a distance from one another in the longitudinal direction, each section having at least one component (21) and two contact surfaces (1, 6) for the power supply.

15. Strip-type arrangement according to one of claims 1 to 14, **characterised in that** it is divided into equal sections by edge cut-outs (57 to 64) situated opposite one another in the transverse direction and arranged at a distance from one another in the longitudinal direction, each section having at least one component (21) and two contact surfaces (1, 6) for the power supply.

16. Strip-type arrangement according to claim 15, **characterised in that** the cut-outs (57 to 64) are designed to be directional, preferably triangular, the tips of two opposing cut-outs being situated opposite one another in the transverse direction.

17. Strip-type arrangement according to claims 14 and 16, **characterised in that** the tips of two opposing triangular cut-outs (57 , 61) are arranged on a cutting line (P1).

18. Strip-type arrangement according to one of claims 14 to 17, **characterised in that** each section (E, F) has at least two adjusting recesses (65 to 74) which are arranged at a distance from one another and can be inserted into corresponding adjusting pins (75 to 78) of a fixing gauge (79) so that it is possible for two adjacent sections separated from one another to be fixed in the fixing gauge (79) in such a manner that their end edges directed towards one another bear against one another in the transverse direction, that a contact bridge (80) can be placed on the regions of the sections (E, F) arranged in the fixing gauge (79) arranged in the fixing gauge (79), the contact bridge being provided on its side directed towards the sections (E, F) with bridge contacts (86, 87) which produce electrical connections between the common conductors (47, 48) of the sections (E, F) in the longitudinal direction when the contact bridge (80) is fixed to the regions of the sections (E, F), and that the contact bridge (80) has recesses (82 to 85) arranged in accordance with the adjusting pins (75 to 78) as an adjusting aid.

19. Strip-type arrangement according to claim 18, **characterised in that** bonding pads (86a, 87a) corresponding to the contact surfaces (1 to 10) for the power supply are arranged in the end regions of the bridge contacts (86, 87) and come to bear against contact surfaces (1 to 10) for the power supply when the contact bridge (80) is fixed.

20. Strip-type arrangement according to claim 18 or claim 19, **characterised in that** the contact bridge (80) is in the form of a plastic sheet to which the bridge contacts (86, 87) and possibly the bonding pads (86a, 87a) are applied, preferably printed thereon, and that the contact bridge (80) has a recess (81) for a component which passes through the recess (81) in the contact bridge (80) in the fixed state of the contact bridge (80).

21. Strip-type arrangement according to one of claims 1 to 20, **characterised in that** a contact clip part (88) is provided, including an upper part (90) and a lower part (91) connected together along an axis of rotation (P3), preferably in the longitudinal direction, in such a manner that the upper part (90) can be folded about the axis of rotation (89) congruently on to the lower part (91), that the lower part has adjusting pins (75 to 78) in which the recesses (82 to 85) of two sections (E, F) to be connected can be inserted in such a manner that the sections (E, F) to be connected bear against one another by means of their end edges extending in the transverse direction, that the upper part (90) is provided on its side directed towards the lower part (91) with bridge contacts (86, 87) which produce electrical connections of the common conductors (47, 48) in the longitudinal direction when the sections (E, F) are fixed between the upper part (90) and the lower part (91) and that the upper part (90) has a recess (94) for the component of a section (E).

22. Strip-type arrangement according to claim 21, **characterised in that** the end regions of the bridge contacts (86, 87) have bonding pads (86a, 87a) which bear against the individual contact surfaces (1 to 10) for the power supply of the sections (E, F) when the upper part is fixed to the lower part (91).

23. Strip-type arrangement according to claim 24, **characterised in that** the upper part (90) and the lower part (91) can be fastened together by a locking device when they bear congruently against one another.

24. Strip-type arrangement according to claim 23, **characterised in that** the locking device has a snap-in projection (93) which is arranged on the side of the upper part (90) or of the lower part (91) situated opposite the axis of rotation (89) in the transverse direction and snaps into a housing opening (92) on the side of the lower part (91) or of the upper part (90) situated opposite the axis of rotation (89) in the transverse direction when the upper part (90) and the lower part (91) bear congruently against one another.

25. Strip-type arrangement according to one of claims 21 to 24, **characterised by** a first sealing ring (95') which surrounds the recess (94) for a component of the upper part (90) on the side directed towards the lower part (91) in such a manner that a component projecting through the recess (94) in the upper part (90) is sealed.

26. Strip-type arrangement according to one of claims 21 to 25, **characterised by** a second sealing ring (95) which surrounds the bridge contacts (86, 87) and possibly the bonding pads (86a, 87a) on the outside and seals the region enclosed thereby when the upper part is fixed to the lower part (91).

27. Strip-type arrangement according to one of claims 1 to 26, **characterised in that** several components (112) are arranged between the common conductors (C, D) of a section in accordance with the pattern of at least one arrow pointing in the longitudinal direction.

28. Strip-type arrangement according to claim 27, **characterised in that** the covering part (26) has a separate cavity for each component (112).

29. Strip-type arrangement according to claim 27, **characterised in that** the covering part (26) has a common cavity (113) for all of the components (112) of a section.

30. Strip-type arrangement according to one of claims 1 to 29, **characterised in that** the components (112) are in the form of light-emitting diodes.

31. Strip-type arrangement according to claim 30, **characterised in that** the light-emitting diodes are single-colour light-emitting diodes.

32. Strip-type arrangement according to claim 30, **characterised in that** the light-emitting diodes are at least partly two-colour light-emitting diodes (115) aligned in such a manner that one colour is visible from one side and the other colour is visible from the other side as viewed in the longitudinal direction.

33. Strip-type arrangement according to one of claims 1 to 32, **characterised in that** two contact surfaces (4, 9) for the power supply situated opposite one another can be contacted in a supply device (54) which can be connected via a cable (55) to a network for the power supply to the common conductors (47, 48) of a section.

## Revendications

1. Agencement en forme de bande comprenant une structure de pistes conductrices (A) et, reliés électriquement à celle-ci, des composants électroniques (21 à 25), notamment une bande lumineuse dotée d'éléments lumineux, la structure de pistes conductrices (A) et les composants (21 à 25) étant agencés sur un support de pistes conductrices (A), et la structure de pistes conductrices (A) comprenant des pistes conductrices (42 à 48), des surfaces de contact (11 à 20) pour des composants, et des surfaces de contact (1 à 10) pour l'alimentation en courant, **caractérisé par** une pièce de recouvrement (26) qui présente des cavités (37 à 41) et des évidements (27 à 36), et qui est reliée de façon étanche au support de pistes conductrices (A) et est agencée sur celui-ci de façon telle, que les composants (21 à 25) s'engagent dans les cavités (37 à 41) et que les surfaces de contact (1 à 10) pour l'alimentation en courant soient agencées dans les évidements (27 à 36) de la pièce de recouvrement (26), ainsi que par une couche de recouvrement (53) recouvrant de manière étanche les surfaces de contact (1 à 10) destinées à l'alimentation en courant et non utilisées pour l'alimentation en courant.

2. Agencement en forme de bande selon la revendication 1, **caractérisé en ce que** le support de pistes conductrices (A) englobe une couche électriquement conductrice et, appliquée sur celle-ci, une couche diélectrique (50), **en ce que** sur la couche diélectrique (50) est agencée une couche (49) qui relie de manière étanche la couche diélectrique (50) à la pièce de recouvrement (26), et **en ce que** sur le côté de la couche diélectrique (50), qui est dirigé vers la pièce de recouvrement (26), sont agencés la structure de pistes conductrices (A) et les composants (21 à 25).

3. Agencement en forme de bande selon la revendication 2, **caractérisé en ce que** la couche électriquement conductrice est une couche d'aluminium (51).

4. Agencement en forme de bande selon la revendication 2 ou 3, **caractérisé en ce que** la couche qui relie de manière étanche la pièce de recouvrement (26) à la couche diélectrique (50), est une couche de vernis de scellement (49), de préférence une couche de vernis de scellement à chaud.

5. Agencement en forme de bande selon l'une des revendications 1 à 4, **caractérisé en ce que** le support de pistes conductrices (A) présente, sur le côté opposé à celui où se trouve la couche de recouvrement (53), une couche adhésive (52) à l'aide de laquelle le support de pistes conductrices (A) peut être collé sur un objet.

6. Agencement en forme de bande selon la revendication 5, **caractérisé en ce que** la couche adhésive (52) est une couche d'adhésif pourvue, sur son côté opposé à celui dirigé vers la pièce de recouvrement, d'une pellicule de protection pouvant être retirée.

7. Agencement en forme de bande selon l'une des revendications 1 à 6, **caractérisé en ce que** la pièce de recouvrement (26) est une pièce en matière plastique dans laquelle les cavités (37 à 41) sont réalisées par emboutissage.

8. Agencement en forme de bande selon l'une des revendications 1 à 7, **caractérisé en ce que** la pièce de recouvrement (26) est une pièce en matière plastique dans laquelle les évidements (27 à 36) sont réalisés par découpage par matriçage.

9. Agencement en forme de bande selon l'une des revendications 1 à 8, **caractérisé en ce que** la pièce de recouvrement (26) est réalisée en un matériau synthétique ou matière plastique, de préférence du PVC.

10. Agencement en forme de bande selon l'une des revendications 1 à 9, **caractérisé en ce que** la structure de pistes conductrices (A) présente une première piste conductrice commune (47) pour l'alimentation en courant, qui s'étend dans la direction longitudinale de l'agencement, et une deuxième piste conductrice commune (48) pour l'alimentation en courant, qui s'étend dans la direction longitudinale, **en ce que** la première et la deuxième piste conductrice sont espacées l'une de l'autre dans la direction transversale, **en ce que** la première piste conductrice commune (47) présente des premières surfaces de contact (1 à 5) pour l'alimentation en courant, qui sont espacées les unes des autres dans la direction longitudinale, et la deuxième piste conductrice commune (48) des deuxièmes surfaces de contact (6 à 10) pour l'alimentation en courant, également espacées les unes des autres dans la direction longitudinale, les premières surfaces de contact (1 à 5) pour l'alimentation en courant et les deuxièmes surfaces de contact (6 à 10) pour l'alimentation en courant étant de préférence situées en regard les unes des autres, par paires, dans la direction transversale, et **en ce que** la structure de pistes conductrices (A) présente par ailleurs, des premières et deuxièmes pistes conductrices individuelles (42 à 46), les premières pistes conductrices individuelles s'étendant à partir de la première piste conductrice (47) pour l'alimentation en courant jusqu'à des premières surfaces de contact (11, 13, 15, 17, 19) pour des composants, et les deuxièmes pistes conductrices individuelles à partir de la deuxième piste conductrice commune (48) jusqu'à des deuxièmes surfaces de contact (12, 14, 16, 18, 20) pour des composants, et un composant (21 à 25) étant agencé respectivement entre une première surface de contact pour des composants et une deuxième surface de contact associée pour des composants.

11. Agencement en forme de bande selon l'une des revendications 1 à 10, **caractérisé en ce que** la pièce de recouvrement (26) est reliée au support de pistes conductrices (A) le long d'une ligne de pliage (100) s'étendant dans la direction longitudinale, et peut être repliée selon un recouvrement coïncidant ou concordant, autour de la ligne de pliage (100), sur le support de pistes conductrices (A) et y être reliée ou assemblée de manière étanche.

12. Agencement en forme de bande selon la revendication 11, **caractérisé en ce que** la pièce de recouvrement (26) est pourvue, sur son côté dirigé vers le support de pistes conductrices (A), d'une couche (97) pour l'assemblage ou la liaison étanche de la pièce de recouvrement (26) avec le support de pistes conductrices (A).

13. Agencement en forme de bande selon la revendication 12, **caractérisé en ce que** la couche (97) est une couche d'adhésif.

14. Agencement en forme de bande selon l'une des revendications 1 à 13, **caractérisé en ce qu'**il est subdivisé en tronçons identiques par des lignes de découpe (P1) espacées les unes des autres dans la direction longitudinale et s'étendant dans la direction transversale, chaque tronçon comprenant au moins un composant (21) et deux surfaces de contact (1, 6) pour l'alimentation en courant.

15. Agencement en forme de bande selon l'une des revendications 1 à 14, **caractérisé en ce qu'**il est subdivisé en tronçons identiques par des encoches de bordure (57 à 64) espacées les unes des autres dans la direction longitudinale et opposées dans la direction transversale, chaque tronçon comprenant au moins un composant (21) et deux surfaces de contact (1, 6) pour l'alimentation en courant.

16. Agencement en forme de bande selon la revendication 15, **caractérisé en ce que** les encoches (57 à 64) sont de configuration à orientation directionnelle, de préférence de forme triangulaire, les pointes de deux encoches opposées étant mutuellement opposées l'une à l'autre dans la direction transversale.

17. Agencement en forme de bande selon les revendications 14 et 16, **caractérisé en ce que** les pointes ou sommets de deux encoches (57, 61) de forme triangulaire mutuellement opposées, sont disposés sur une ligne de découpe (P1).

18. Agencement en forme de bande selon l'une des revendications 14 à 17, **caractérisé en ce que** chaque tronçon (E, F) présente au moins deux évidements d'ajustage (65 à 74) qui sont espacés les uns des autres et peuvent être introduits dans des tenons d'ajustage (75 à 78) correspondants d'un gabarit de fixation (79), pour pouvoir fixer deux tronçons voisins, séparés l'un de l'autre, dans le gabarit de fixation (79), de façon telle que leurs bords d'extrémité dirigés l'un vers l'autre soient jointifs dans la direction transversale, **en ce que** sur les zones des tronçons (E, F) agencés dans le gabarit de fixation (79), qui sont situées dans le gabarit de fixation (79), peut être déposé un pontage de connexion (80) qui, sur son côté dirigé vers les tronçons (E, F), comporte des contacts de pontage (86, 87) réalisant, dans la direction longitudinale, des liaisons électriques entre les pistes conductrices communes (47, 48) des tronçons (E, F) lorsque le pontage de connexion (80) est fixé aux dites zones des tronçons (E, F), et **en ce que** le pontage de connexion (80) présente, en guise d'aide à l'ajustage, des évidements (82, 85) agencés de manière correspondante aux tenons d'ajustage (75 à 78).

19. Agencement en forme de bande selon la revendication 18, **caractérisé en ce qu'**au niveau des zones d'extrémité des contacts de pontage (86, 87) sont agencées des pastilles de contact (86a, 87a) correspondant aux surfaces de contact (1 à 10) pour l'alimentation en courant et venant se placer, lors de la fixation du pontage de connexion (80), sur des surfaces de contact (1 à 10) pour l'alimentation en courant.

20. Agencement en forme de bande selon la revendication 18 ou 19, **caractérisé en ce que** le pontage de connexion (80) présente la forme d'une plaquette de matière plastique sur laquelle sont appliqués, de préférence imprimés, les contacts de pontage (86, 87) et, le cas échéant, les pastilles de contact (86a, 87a), et **en ce que** le pontage de connexion (80) présente un évidement (81) pour un composant qui, dans l'état fixé du pontage de connexion (80), traverse l'évidement (81) du pontage de connexion (80).

21. Agencement en forme de bande selon l'une des revendications 1 à 20, **caractérisé en ce qu'**il est prévu une pièce de contact à clipser (88) comprenant une partie supérieure (90) et une partie inférieure (91), qui sont reliées l'une à l'autre le long d'un axe de rotation (P3) de préférence dans la direction longitudinale, de façon telle que la partie supérieure (90) puisse être rabattue autour de l'axe de rotation (89) de manière concordante sur la partie inférieure (91), **en ce que** la partie inférieure présente des tenons d'ajustage (75 à 78) sur lesquels peuvent être placés les évidements (82 à 85) de deux tronçons (E, F) à relier, de manière à ce que les tronçons (E, F) à relier soient jointifs avec leurs bords d'extrémité s'étendant dans la direction transversale, **en ce que** la partie supérieure (90) présente, sur son côté dirigé vers la partie inférieure (91), des contact de pontage (86, 87) qui établissent dans la direction longitudinale, des liaisons ou connexions électriques des pistes conductrices communes (47, 48) lorsque les tronçons (E, F) sont fixés entre la partie supérieure (90) et la partie inférieure (91), et **en ce que** la partie supérieure (90) présente un évidement (94) pour le composant d'un tronçon (E).

22. Agencement en forme de bande selon la revendication 21, **caractérisé en ce que** les zones d'extrémité des contacts de pontage (86, 87) présentent des pastilles de contact (86a, 87a) qui viennent s'appliquer sur les surfaces de contact individuelles (1 à 10) pour l'alimentation en courant des tronçons (E, F), lorsque la partie supérieure (90) est fixée sur la partie inférieure (91).

23. Agencement en forme de bande selon la revendication 22, **caractérisé en ce que** la partie supérieure (90) et la partie inférieure (91) peuvent être fixées l'une à l'autre par un dispositif de verrouillage lorsqu'elles sont superposées de manière concordante.

24. Agencement en forme de bande selon la revendication 23, **caractérisé en ce que** le dispositif de verrouillage comporte un talon d'encliquetage (93) agencé sur le côté de la partie supérieure (90) ou de la partie inférieure (91), qui, dans la direction transversale, est opposé à l'axe de rotation (89), le talon d'encliquetage venant s'engager par encliquetage dans une ouverture de passage de boitier (92) sur le côté de la partie inférieure (91) ou de la partie supérieure (90), qui, dans la direction transversale, est opposé à l'axe de rotation (89), lorsque la partie supérieure (90) et la partie inférieure (91) sont superposées de manière concordante.

25. Agencement en forme de bande selon l'une des revendications 21 à 24, **caractérisé en ce qu'**il est prévu un premier anneau d'étanchéité (95') qui entoure l'évidement (94) pour un composant de la partie supérieure (90), sur le côté dirigé vers la partie inférieure (91), de façon à produire une étanchéité d'un composant faisant saillie à travers l'évidement (94) de la partie supérieure (90).

26. Agencement en forme de bande selon l'une des revendications 21 à 25, **caractérisé en ce qu'**il est prévu un deuxième anneau d'étanchéité (95) qui entoure extérieurement les contacts de pontage (86, 87) et le cas échéant les pastilles de contact (86a, 87a), et produit une étanchéité de la zone qu'il entoure lorsque la partie supérieure est fixée à la partie inférieure (91).

27. Agencement en forme de bande selon l'une des revendications 1 à 26, **caractérisé en ce que** plusieurs composants (112) sont agencés, selon le modèle d'au moins une flèche dirigée dans la direction longitudinale, entre les pistes conductrices communes (C, D) d'un tronçon.

28. Agencement en forme de bande selon la revendication 27, **caractérisé en ce que** la pièce de recouvrement (26) présente de manière correspondante une cavité propre à chaque composant (112).

29. Agencement en forme de bande selon la revendication 27, **caractérisé en ce que** la pièce de recouvrement (26) présente une cavité (113) commune pour tous les composants (112) d'un tronçon.

30. Agencement en forme de bande selon l'une des revendications 1 à 29, **caractérisé en ce que** les composants (112) présentent la forme de diodes émettrices de lumière.

31. Agencement en forme de bande selon la revendication 30, **caractérisé en ce que** les diodes émettrices de lumière sont des diodes luminescentes à une couleur.

32. Agencement en forme de bande selon la revendication 30, **caractérisé en ce que** les diodes émettrices de lumière sont au moins en partie des diodes luminescentes (115) à deux couleurs, qui sont orientées de façon telle que, vues dans la direction longitudinale, une couleur soit visible à partir d'un côté et l'autre couleur soit visible à partir de l'autre côté.

33. Agencement en forme de bande selon l'une des revendications 1 à 32, **caractérisé en ce que** deux surfaces de contact mutuellement opposées (4, 9) pour l'alimentation en courant peuvent être connectées dans un dispositif d'alimentation (54) pouvant être relié à un réseau par un câble (55), en vue de réaliser l'alimentation en courant des pistes conductrices communes (47, 48) d'un tronçon.
